Europäisches Patentamt

(19) European Patent Office

Office européen des brevets

(11) Publication number: **0 000 638**

**B1**

(12) **EUROPEAN PATENT SPECIFICATION**

(21) Application number: 78300157.1

(22) Date of filing: 17.07.78

(51) Int. Cl.³: **H 01 L 29/04,**
**H 01 L 27/15,**
**H 01 L 21/208, G 02 F 1/09**

(54) Devices including epitaxial layers of dissimilar crystalline materials.

(30) Priority: 14.07.77 US 815720

(43) Date of publication of application:
07.02.79 Bulletin 79/3

(45) Publication of the grant of the European patent:
25.02.81 Bulletin 81/8

(84) Designated Contracting States:
BE DE FR GB NL SE

(56) References cited:
BE - A - 751 978
DE - A - 2 454 183
FR - A - 2 280 166
US - A - 3 922 703

APPLIED PHYSICS LETTERS, vol. 21, nr. 5, 1
September 1972,
New York, USA
P. K. THIEN et al. "Optical waveguides of single-
crystal garnet films", pages 207—209

IBM TECHNICAL DISCLOSURE BULLETIN, vol.
15, nr. 1, June 1972,
New York, USA,
E. A. GIESS et al. "Growth of single crystal
$MgGa_2O_4$ Spinel", pages 151—152
IEEE TRANSACTIONS ON MICROWAVE THEORY
AND TECHNIQUES, vol. MTT—23, nr. 1, January
1975,
New York USA,
J. WARNER "Nonreciprocal magneto-optic
waveguides", pages 70—78

(73) Proprietor: **Western Electric Company,
Incorporated
222 Broadway
New York N.Y. 10038 (US)**

(72) Inventor: **Tien, Ping King
19 Lisa Drive
Chatham New Jersey 07928 (US)**

(74) Representative: **Watts, Christopher Malcolm
Kelway, Dr. et al,
Western Electric Company Limited 5, Mornington
Road
Woodford Green Essex, IG8 0TU (GB)**

Courier Press, Leamington Spa, England.

# 0 000 638

## Devices including epitaxial layers of dissimilar crystalline materials

This invention relates to devices including a first crystalline layer and a second crystalline layer epitaxially formed on at least a portion of the first layer.

Whilst hetero-epitaxy is known to be possible between materials whose lattice constants in the free crystalline state are not closely matched, examples of such epitaxial systems, including gallium arsenide on gadolinium gallium garnet, being disclosed in Belgian patent No. 751.978, it is only at the expense of interfacial stresses which tend to produce imperfections near the interface. Lattice matching, in which the materials are chosen so that the lattice constants are very closely equal to one another, is known as a means for avoiding such stresses, but this greatly limits the choice of materials which can be combined in an epitaxial structure.

One known technique for combining materials with different lattice constants, which is disclosed in U.S. patent No. 4,032,951, is to form an intermediate layer of graded chemical composition to provide a transition zone between one lattice constant and the other.

In the invention as claimed the lattice constants of the materials differ by a factor which is substantially equal to an integer other than unity. We have found that by this means the advantages known to arise from lattice matching can be obtained with combinations of materials which were previously considered to be incompatible from the point of view of lattice-matched epitaxy.

For example it is highly desirable to be able to combine in one integrated optical device an electro-optic device such as a semiconductor injection laser with a magneto-optic device such as an optical switch, and for this purpose it is desirable to have an epitaxial system comprising a semiconductor layer and a garnet layer. With our invention it is possible to provide such a system without foregoing the advantages of lattice-matched epitaxy.

Some embodiments of the invention will now be described by way of example with reference to the accompanying drawings of which:—

FIG. 1 shows an injection diode laser constructed according to the invention;

FIG. 2 shows a pictorial view of an integrated optical circuit including magnetic and optical devices;

FIG. 2A shows a section through FIG. 2; and

FIG. 3 shows a plot of the lattice constants of the iron, aluminium and gallium garnets against ionic radius of the added rare-earth element.

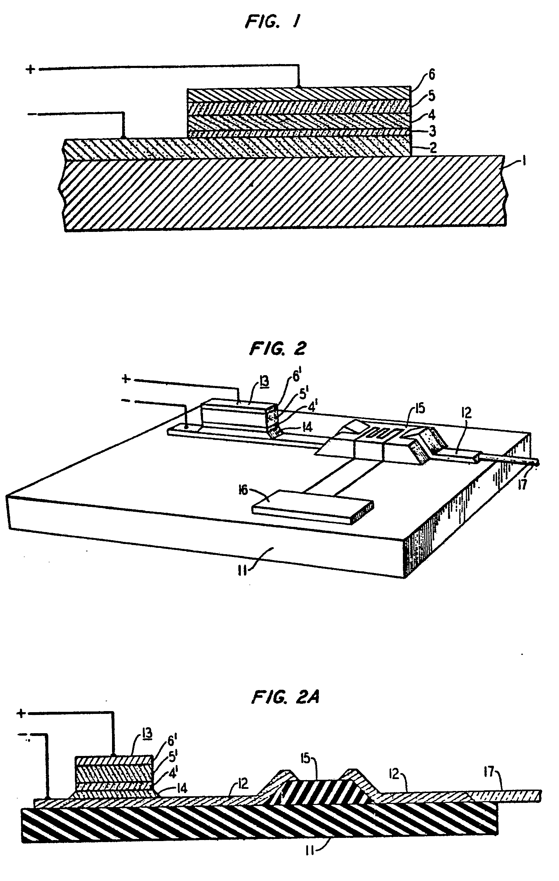

As an illustration of a device constructed according to the invention, consider the double heterostructure injection diode laser shown in FIG. 1, in which a first crystalline layer, garnet substrate 1, which is suitable for magneto-optic devices, has an epitaxially grown second crystalline layer of an n-type III—V semiconductor 2 that is conductive and serves both as the n-buffer layer and as one contact. The double heterostructure of the diode laser includes an active region 3, p-cladding layer 4, $p^+$ layer 5 and contact 6 in conventional fashion.

Illustratively, substrate I is Yttrium Aluminum Garnet (YAG) having a lattice constant of 1.2 nm and the III—V compound of layer 2 is AlInAs, compounded to have a lattice constant of 0.6 nm and an energy gap of .68 eV, capable of emitting radiation at 1.82 $\mu$m.

In FIG. 2, an integrated-optics device for generating an optical carrier, modulating the carrier and transmitting the modulated carrier into a fiber-optic waveguide is shown in which substrate 11 and thin film waveguide 12 are formed of a garnet and a III—V compound respectively, with lattice constants adjusted for an integral ratio.

Laser 13 is another version of the semiconductor injection laser known as the twin-guide laser, in which laser light generated in active layer 14 is coupled to waveguide 12 below, through a tapered transition. Waveguide 12 also serves as one of the electric contacts of the laser. Layers 4', 5', and 6' are equivalent to layers 4, 5, and 6 in FIG. 1. The radiation from laser 13 then travels through waveguide 12 into and out of a magneto-optic switch 15 which is formed from a garnet-based material directly on garnet substrate 11. The method of the coupling using tapered edges of the films and the magneto-optic switch described here are earlier inventions of the present inventor (U.S. Patent 3,764,195 and 4,806,226). The laser, switch and waveguides of various shapes can be grown on the garnet substrate by the method of "selective growth" which is well known in epitaxial technology. Switch 15, controlled by electronics logic circuit 16, illustratively a time-division multiplexer that combines input bit streams (arriving on contacts not shown), forms a modulated radiation beam that continues through waveguide 12 to optical fiber 17 for transmission.

FIG. 2A shows a section along waveguide 12 through the centerline of devices 13 and 15 and of waveguide 12, indicating by cross-hatching the garnet and semiconductor components of the device. In particular, active region 14 of laser 1 and waveguide 12 are both formed from III—V semiconductors (differently doped), and magneto-optic switch 15 and substrate 11 are formed from garnet-based compounds.

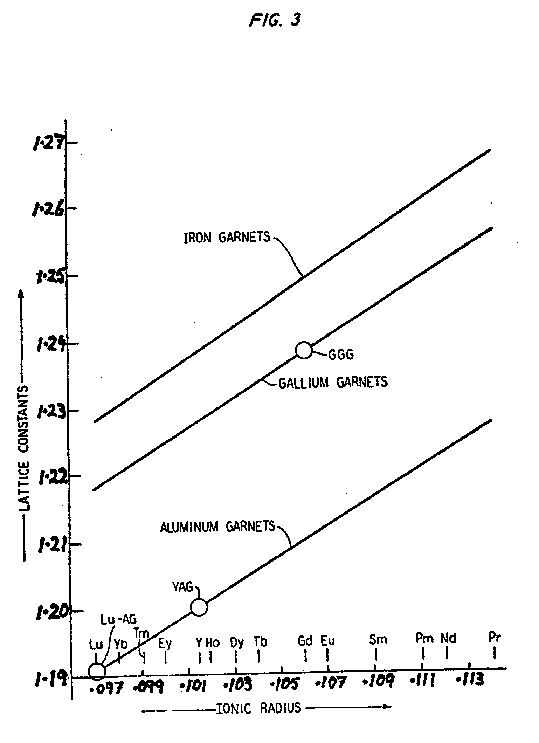

FIG. 3 shows a graph plotting the lattice constants of all the iron, gallium and aluminum garnets against ionic radius of the added rare-earth element. Individual elements are indicated at the appropriate ionic radius, and the positions of three well-known garnets are indicated by circles — GGG

2

(Gd—Ga—Garnet), YAG (Y—Al—Garnet) and LuAG (Lu—Al—Garnet).

The graph provides the numerical value of the lattice constant of a particular garnet compound, so that an appropriate III—V semiconductor may be formed to provide an integral ratio of lattice constants. The method of calculating the composition of a III—V compound that has a particular lattice constant is a straightforward application of Vegard's law and is well known in the art. (See *Physics of III—V Compounds,* Madelung and Meyerhofer, Wiley, N.Y., 1964, page 272).

As an example, combinations of a garnet substrate with a III—V semiconductor compound are indicated in Table I, which shows for each of three garnets the lattice constants of the garnet, a ternary or quaternary III—V semiconductor compound with lattice constant half that of the garnet, and the wavelength of light emitted by a laser formed from that III—V compound. Other combinations of garnets and III—V compounds will be apparent to those skilled in the art.

In addition to the injection laser described above and shown in FIG. 1, optically pumped lasers may be formed from the materials shown in Table I. The garnets are transparent and lossless at wavelengths considered. The indices of refraction differ considerably (n=1.8 or 1.9 for the garnets, and n>3.2 for the III—V compounds) so that excellent waveguides and lasers can be made.

In addition to the production of solid state lasers, the invention may be used for the production of light-emitting diodes of desired frequency, where the frequency of the light emitted depends on the chemical composition of the device and therefore on the lattice constant.

It is also possible to apply the invention to electrical devices other than those considered above, so that new combinations of compounds will be possible in the fabrication of transistors and other electronic devices.

TABLE I
Wavelengths of III—V Semiconductor Lasers
with Lattice Constant Half that of a Garnet
III—V Ternary Compounds

| Garnet Compound | | III—V Semiconductor (Compounded for Half the Garnet Lattice Constant) | |
| --- | --- | --- | --- |
| Garnet Composition | Lattice Constant (nm) | Composition | Wavelength ($\mu$m) |
| LuAG | 1.191 | $Al_xIn_{1-x}As$ | 1.19 |
| | | $InP_xAs_{1-x}$ | 1.24 |
| | | $GaAs_xSb_{1-x}$ | 1.79 |
| | | $InGa_{1-x}As_x$ | 1.90 |
| YAG | 1.2 | $Al_xIn_{1-x}As$ | 1.82 |
| | | $InP_xAs_{1-x}$ | 2 |
| | | $GaAs_xSb_{1-x}$ | 1.87 |
| | | $InGa_{1-x}As_x$ | 2.43 |
| GGG | 1.238 | $InAs_xSb_{1-x}$ | 6.9 |

III—V Quarternary Compounds

| Garnet Compound | | III—V Semiconductor (Compounded for Half the Garnet Lattice Constant) | |
| --- | --- | --- | --- |
| Garnet Composition | Lattice Constant (nm) | Composition | Wavelength ($\mu$m) |
| LuAG | 1.191 | $(Al_xIn_{1-x})_yGa_{1-y}As$ | 1.19—1.90 |
| | | $Al_xIn_{1-x}P_yAs_{1-y}$ | 1.19—1.24 |
| YAG | 1.2 | $(Al_xIn_{1-x})_yGa_{1-y}As$ | 1.82—2.43 |
| | | $Al_xIn_{1-x}P_yAs_{1-y}$ | 1.82—2 |
| GGG | 1.238 | $(Al_xGa_{1-x})_yIn_{1-y}Sb$ | 1.16—1.29 |
| | | $Al_xIn_{1-x}As_ySb_{1-y}$ | .79—3.44 |

**Claims**

1. A device including a first crystalline layer (1, 11) of a material which in the free crystalline state has a lattice constant $A_1$ and a second crystalline layer (2, 12) epitaxially formed on at least a portion of the first layer and of a material which in the free crystalline state has a lattice constant $A_2$ *characterised in that* one of the two ratios $A_1/A_2$ and $A_2/A_1$ of the said lattice constants is substantially equal to an integer other than unity.

2. A device as claimed in claim 1 wherein the second layer (2, 12) is of a semiconductor material.

3. A device as claimed in claim 2 wherein the semiconductor is a compound comprising elements from groups III and V of the periodic table of elements.

4. A device as claimed in any of the preceding claims wherein the first layer (1, 11) is of a garnet material.

5. A device as claimed in claim 4 as dependent on claim 3 wherein the garnet material is lutetium-aluminium-garnet, yttrium-aluminium-garnet or gadolinium-gallium-garnet and the semiconductor material is a substituted III—V compound having a lattice constant substantially equal to half the lattice constant of the garnet.

6. A device as claimed in any of the preceding claims comprising at least two optical devices (13, 15) epitaxially grown respectively on the second layer and directly on the first layer.

7. A device as claimed in claim 6 wherein one of the devices (15) is a magneto-optical device.

8. A device as claimed in claim 6 or claim 7 wherein one of the devices (13) is an electro-optical device.

9. A device as claimed in claim 8 wherein the electro-optical device is a light-emitting device.

10. A device as claimed in claim 9 wherein the light-emitting device is a solid-state injection laser.

## Patentansprüche

1. Vorrichtung mit einer ersten kristallinen Schicht (1, 11) aus einem Material, das im freien Kristallzustand eine Gitterkonstante $A_1$ hat, und mit einer zweiten, epitaktisch auf wenigstens einem Teil der ersten Schicht gebildeten kristallinen Schicht (2, 12) aus einem Material, das im freien Kristallzustand eine Gitterkonstante $A_2$ hat, dadurch gekennzeichnet, daß eines der beiden Verhältnisse $A_1/A_2$ und $A_2/A_1$ der Gitterkonstanten im wesentlichen gleich einer ganzen Anzahl außer Eins ist.

2. Vorrichtung nach Anspruch 1, bei der die zweite Schicht (2, 12) aus einem Halbleitermaterial besteht.

3. Vorrichtung nach Anspruch 2, bei der der Halbleiter eine Verbindung aus Elementen der III. und V. Gruppe des Periodischen Systems der Elemente ist.

4. Vorrichtung nach einem der vorhergehenden Ansprüche, bei der die erste Schicht (1, 11) aus einem Granatmaterial besteht.

5. Vorrichtung nach Anspruch 4, in Abhängigkeit von Anspruch 3, bei der das Granat-Material Lutetium-Aluminiumgranat, Yttrium-Aluminiumgranat oder Gadolinium-Galliumgranat und das Halbleitermaterial eine substituierte III—V-Verbindung mit einer Gitterkonstanten ist, die im wesentlichen gleich der halben Gitterkonstante des Granats ist.

6. Vorrichtung nach einem der vorhergehenden Ansprüche, die wenigstens zwei optische Bauteile (13, 15) aufweist, welche epitaktisch auf der zweiten Schicht bzw. direkt auf der ersten Schicht aufgewachsen sind.

7. Vorrichtung nach Anspruch 6, bei der eines Bauteile (15) ein magneto-optisches Bauteil ist.

8. Vorrichtung nach Anspruch 6 oder 7, bei der eines der Bauteile (13) ein elektro-optisches Bauteil ist.

9. Vorrichtung nach Anspruch 8, bei der das elektro-optische Bauteil ein licht-emitierendes Bauteil ist.

10. Vorrichtung nach Anspruch 9, bei der das licht-emitierende Bauteil ein Festkörper-Injektionslaser ist.

## Revendications

1. Dispositif comprenant une première couche cristalline (1, 11) en une matière qui à l'état cristallin libre a une constante de réseau $A_1$ et une seconde couche cristalline (2, 12) qui est formée par épitaxie sur une partie au moins de la première couche et qui consiste en une matière qui à l'état cristallin libre a une constante de réseau $A_2$, *caractérisé en ce que* l'un des deux rapports $A_1/A_2$ et $A_2/A_1$ entre ces constantes de réseau est pratiquement égal à un entier autre que l'unité.

2. Dispositif selon la revendication 1, dans lequel la seconde couche (2, 12) consiste en une matière semiconductrice.

3. Dispositif selon la revendication 2, caractérisé en ce que le semiconducteur est un composé comprenant des éléments des groupes III et V de la table périodique des éléments.

4. Dispositif selon l'une quelconque des revendications précédentes, dans lequel la première couche (1, 11) consiste en un grenat.

5. Dispositif selon la revendication 4, considérée comme dépendant de la revendication 3, dans lequel le grenat est un grenat de lutécium-aluminium, un grenat d'yttrium-aluminium ou un grenat de gadolinium-gallium, et la matière semiconductrice est un composé III—V substitué ayant une constante de réseau pratiquement égale à la moitié de la constante de réseau du grenat.

6. Dispositif selon l'une quelconque des revendications précédentes comprenant au moins deux dispositifs optiques (13, 15) réalisés par croissance épitaxiale, respectivement sur la seconde couche et directement sur la première couche.

7. Dispositif selon la revendication 6, dans lequel l'un des dispositifs (15) est un dispositif magnéto-optique.

8. Dispositif selon la revendication 6 ou la revendication 7 dans lequel l'un des dispositifs (13) est un dispositif électro-optique.

9. Dispositif selon la revendication 8, dans lequel le dispositif électro-optique est un dispositif émetteur de lumière.

10. Dispositif selon la revendication 9, dans lequel le dispositif émetteur de lumière est un laser à injection à l'état solide.

## FIG. 1

## FIG. 2

## FIG. 2A

1

FIG. 3